Europäisches Patentamt

European Patent Office

Office européen des brevets

(19)

(11) Veröffentlichungsnummer: **0 049 795**

**A2**

(12) **EUROPÄISCHE PATENTANMELDUNG**

(21) Anmeldenummer: **81107668.6**

(22) Anmeldetag: **26.09.81**

(51) Int. Cl.³: **H 03 K 17/945**
**G 08 B 13/00**

(30) Priorität: **09.10.80 DE 3038102**

(43) Veröffentlichungstag der Anmeldung:
**21.04.82 Patentblatt 82/16**

(84) Benannte Vertragsstaaten:
**AT BE CH FR GB IT LI LU NL SE**

(71) Anmelder: **Buck, Robert**
**Am Kirchbühl 28**
**D-7995 Neukirch(DE)**

(71) Anmelder: **Marhofer, Gerd**
**Beckmannsbusch 67**
**D-4300 Essen-Bredeney(DE)**

(72) Erfinder: **Buck, Robert**
**Am Kirchbühl 28**
**D-7995 Neukirch(DE)**

(72) Erfinder: **Marhofer, Gerd**
**Beckmannsbusch 67**
**D-4300 Essen-Bredeney(DE)**

(74) Vertreter: **Gesthuysen, Hans Dieter, Dipl.-Ing.**
**Huyssenallee 15**
**D-4300 Essen 1(DE)**

(54) **Elektronisches, berührungslos arbeitendes Schaltgerät.**

(57) Dargestellt und beschrieben ist ein elektronisches, berührungslos arbeitendes Schaltgerät (1), mit einem von außen beeinflußbaren Anwesenheitsindikator (2), einem von dem Anwesenheitsindikator (2) steuerbaren elektronischen Schalter (3), z. B. einem Transistor, einem Thyristor oder einem Triac, und einem Zustandsindikator (4), wobei der Anwesenheitsindikator (2) dann den Schaltzustand des elektronischen Schalters (3) umsteuert, wenn der Beeinflussungszustand des Anwesenheitsindikators (2) eine vorgegebene Ansprechschwelle überschreitet, und wobei durch den Zustandsindikator (4) unterschiedliche Beeinflussungszustände des Anwesenheitsindikators (2) angezeigt werden, nämlich

Anwesenheitsindikator (2) nicht beeinflußt (Beeinflussungszustand I),

Anwesenheitsindikator (2) innerhalb eines mittleren Beeinflussungsbebereiches beeinflußt (Beeinflussungszustand II),

Anwesenheitsindikator (2) oberhalb des mittleren Beeinflussungsbereiches beeinflußt (Beeinflussungszustand III).

Zur Verbesserung einerseits der Aussagekraft der Zustandsindikation andererseits der Funktionstüchtigkeit zu erreichen, ist der mittlere Beeinflussungsbereich des Anwesenheitsindikators (2) (Beeinflussungszustand II) in einen unterhalb der Ansprechstelle liegenden Beeinflussungsbereich (Beeinflussungszustand IIa) und einen oberhalb der Ansprechschwelle liegenden Beeinflussungsbereich (Beeinflussungszustand IIb) unterteilt.

**Fig.1**

— 1 —

Die Erfindung betrifft ein elektronisches, berührungslos arbeitendes
Schaltgerät, mit einem von außen beeinflußbaren Anwesenheitsindikator,
einem von dem Anwesenheitsindikator steuerbaren elektronischen Schalter,
z. B. einem Transistor, einem Thyristor oder einem Triac, und einem Zustandsindikator, wobei der Anwesenheitsindikator dann den Schaltzustand
des elektronischen Schalters umsteuert, wenn der Beeinflussungszustand
des Anwesenheitsindikators eine vorgegebene Ansprechschwelle überschreitet, und wobei durch den Zustandsindikator unterschiedliche Beeinflussungszustände des Anwesenheitsindikators - Anwesenheitsindikator nicht beeinflußt (Beeinflussungszustand I), Anwesenheitsindikator innerhalb eines
mittleren Beeinflussungsbereiches beeinflußt (Beeinflussungszustand II),
Anwesenheitsindikator oberhalb des mittleren Beeinflussungsbereiches beeinflußt (Beeinflussungszustand III) - angezeigt werden.

Elektronische Schaltgeräte, die also kontaktlos ausgeführt sind, werden
in zunehmendem Maße anstelle von elektrischen, mechanisch betätigten Schaltgeräten, die kontaktbehaftet ausgeführt sind, in elektrischen Meß-, Steuer-
und Regelkreisen verwendet. Dies gilt insbesondere für sogenannte Annäherungsschalter, d. h. für elektronische Schaltgeräte, die berührungslos arbeiten. Mit solchen Annäherungsschaltern wird indiziert, ob sich ein Beeinflussungselement, für das der entsprechende Annäherungsschalter sensitiv ist, dem Annäherungsschalter hinreichend weit genähert hat. (Hat sich
nämlich ein Beeinflussungselement, für das der entsprechende Annäherungsschalter sensitiv ist, dem Anwesenheitsindikator hinreichend weit genähert,
so steuert der Anwesenheitsindikator den elektronischen Schalter um, - d. h.
bei einem als Schließer ausgeführten Schaltgerät wird der nicht leitende
elektronische Schalter nunmehr leitend, während bei einem als Öffner ausgeführten Schaltgerät der leitende elektronische Schalter nunmehr sperrt.)

Wesentlicher Bestandteil von elektronischen Schaltgeräten der eingangs
und zuvor beschriebenen Art ist also u. a. der von außen beeinflußbare Anwesenheitsindikator. Als Anwesenheitsindikator kann z. B. ein induktiv oder kapazitiv beeinflußbarer Oszillator vorgesehen sein; es handelt sich dann um induktive oder kapazitive Annäherungsschalter. Als Anwesenheitsindikator kann z. B. auch ein Lichtempfänger, z. B. ein Fotowiderstand, eine Fotodiode oder ein Fototransistor, vorgesehen sein; es handelt sich dann um optoelektronische Annäherungsschalter.

(Optoelektronische Annäherungsschalter weisen einen Lichtsender und einen Lichtempfänger auf und werden auch als Lichtschranken bezeichnet. Dabei unterscheidet man zwischen einem Lichtschrankentyp, bei dem der Lichtsender und der Lichtempfänger auf entgegengesetzten Seiten einer Überwachungsstrecke angeordnet sind, und einem Lichtschrankentyp, bei dem der Lichtsender und der Lichtempfänger am gleichen Ende einer Überwachungsstrecke angeordnet sind, während ein am anderen Ende der Überwachungsstrecke angeordneter Reflektor den vom Lichtsender ausgehenden Lichtstrahl zum Lichtempfänger zurück reflektiert. In beiden Fällen spricht der Anwesenheitsindikator an, wenn der normalerweise vom Lichtsender zum Lichtempfänger gelangende Lichtstrahl durch ein in die Überwachungsstrecke gelangtes Beeinflussungselement unterbrochen wird. Es gibt jedoch auch Lichtschranken des zuletzt beschriebenen Lichtschrankentyps, bei dem der vom Lichtsender kommende Lichtstrahl nur durch ein entsprechendes Beeinflussungselement zum Lichtempfänger zurück reflektiert wird.)

Im folgenden werden als Beispiel immer optoelektronische Annäherungsschalter behandelt. Gleichwohl gelten alle Ausführungen jedoch immer auch für andere Arten von elektronischen Schaltgeräten der eingangs beschriebenen und zuvor erläuterten Art, insbesondere für induktive und für kapazitive Annäherungsschalter.

Ein weiterer wesentlicher Bestandteil von elektronischen Schaltgeräten der eingangs und zuvor beschriebenen Art ist der Zustandsindikator, durch den unterschiedliche Beeinflussungszustände des Anwesenheitsindikators angezeigt werden.

Zunächst sind elektronische, berührungslos arbeitende Schaltgeräte mit einem Zustandsindikator bekannt, bei denen der Zustandsindikator, der z. B. als Licht emittierende Diode (LED) ausgeführt ist, nur durch die dualen Informationen "Ansprechschwelle unterschritten" und "Ansprechschwelle überschritten" liefert; wenn der Zustandsindikator als Licht emittierende Diode (LED) ausgeführt ist, sind die dualen Informationen "die Licht emittierende Diode (LED) leuchtet nicht" oder "die Licht emittierende Diode (LED) leuchtet". Regelmäßig ist dabei der Zustandsindikator so an das übrige Schaltgerät angeschlossen, daß er die dualen Informationen "elektro- nischer Schalter gesperrt" bzw. "elektronischer Schalter leitend" liefert.

Bei dem eingangs beschriebenen Schaltgerät, von dem die Erfindung ausgeht, einem optoelektronischen Annäherungsschalter, liefert der Zustandsindikator nicht nur die beiden zuvor erläuterten dualen Informationen. Vielmehr werden drei unterschiedliche Informationen geliefert, nämlich die Informationen "Anwesenheitsindikator nicht beeinflußt (Beeinflussungszustand I)", "Anwesenheitsindikator innerhalb eines mittleren Beeinflussungsbereiches beeinflußt (Beeinflussungszustand II)" und "Anwesenheitsindikator oberhalb des mittleren Beeinflussungsbereiches beeinflußt (Beeinflussungszustand III)". Dabei ist der Zustandsindikator als besondere Licht emittierende Diode (LED) ausgeführt, die in Abhängigkeit von der Lichtstärke des den Lichtempfänger treffenden Lichtstrahls "nicht leuchtet", "rot leuchtet" oder "grün leuchtet". Die Licht emittierende Diode (LED) leuchtet dann rot, wenn der Anwesenheitsindikator innerhalb eines mittleren Beeinflussungsbereiches (Beeinflussungszustand II) beeinflußt ist. Damit verbunden ist die Information, daß ein stabiler Schaltzustand nicht vorliegt, daß sich vielmehr der existente Schaltzustand durch äußere Einflüsse, z. B. durch Temperaturschwankungen, ändern kann.

Der Erfindung liegt nun die Aufgabe zugrunde, das Schaltgerät der eingangs beschriebenen und zuvor im einzelnen erläuterten Art einerseits in bezug auf die Aussagekraft der Zustandsindikation, andererseits in bezug auf seine Funktionstüchtigkeit als elektronisches, berührungslos arbeitendes Schaltgerät zu verbessern.

Das erfindungsgemäße Schaltgerät, bei dem die zuvor aufgezeigte Aufgabe gelöst ist, ist zunächst und im wesentlichen dadurch gekennzeichnet, daß der mittlere Beeinflussungsbereich des Anwesenheitsindikators (Beeinflussungszustand II) in einen unterhalb der Ansprechschwelle liegenden Beeinflussungsbereich (Beeinflussungszustand IIa) und in einen oberhalb der Ansprechschwelle liegenden Beeinflussungsbereich (Beeinflussungszustand IIb) unterteilt ist.

Bei dem elektronischen, berührungslos arbeitenden Schaltgerät, von dem die Erfindung ausgeht, kann der Zustandsindikator, wie dargelegt, die Information liefern, daß ein stabiler Schaltzustand nicht vorliegt, daß sich vielmehr der existente Schaltzustand durch äußere Einflüsse, z. B. durch Temperaturschwankungen, ändern kann. Ist nun der Schaltzustand, der als labiler Schaltzustand die Licht emittierende Diode (LED) rot aufleuchten läßt, der Schaltzustand "elektronischer Schalter leitend" (bei einem als Schließer ausgeführten Schaltgerät, umgekehrt bei einem als Öffner ausgeführten Schaltgerät), so enthält diese Zustandsindikation keine Aussage darüber, wohin dieser labile Schaltzustand tendiert, - zu dem labilen Schaltzustand "elektronischer Schalter gesperrt" oder zu dem stabilen Schaltzustand "elektronischer Schalter leitend". (Entsprechendes gilt, wenn der Schaltzustand, der als labiler Schaltzustand die Licht emittierende Diode (LED) rot aufleuchten läßt, der Schaltzustand "elektronischer Schalter gesperrt" ist.) Demgegenüber liefert bei dem erfindungsgemäßen Schaltgerät der Zustandsindikator - neben den Zustandsindikationen "elektronischer Schalter gesperrt, stabiler Schaltzustand" (Beeinflussungszustand I) bzw. "elektronischer Schalter leitend, stabiler Schaltzustand" (Beeinflussungszustand III) - die Zustandsindikationen "elektronischer Schalter gesperrt, labiler Schaltzustand"(Beeinflussungszustand IIa) und "elektronischer Schalter leitend, labiler Schaltzustand" (Beeinflussungszustand IIb). Diese Zustandsindikationen sind eine wertvolle Justierhilfe beim Einbau solcher Schaltgeräte, - so daß der Slogan "Einbauen und Vergessen" gerechtfertigt ist.

Elektronische Schaltgeräte der in Rede stehenden Art werden oft als sogenannte Zweileitergeräte ausgeführt, d. h. sie weisen insgesamt nur zwei
Anschlußleiter auf, - wie dies bei elektromechanischen, kontaktbehafteten
Schaltgeräten auch der Fall ist. Im Gegensatz zu elektromechanischen, kontaktbehafteten Schaltgeräten benötigen elektronische Schaltgeräte der in
Rede stehenden Art aber sowohl im Schaltzustand "elektronischer Schalter
gesperrt" als auch im Schaltzustand "elektronischer Schalter leitend"
elektrische Energie; d. h. über solche elektronischen Schaltgeräte fließt
auch im Schaltzustand "elektrischer Schalter gesperrt" Strom und an
solchen elektronischen Schaltgeräten tritt auch im Schaltzustand "elektronischer Schalter leitend" ein Spannungsabfall auf.

Wenn es nun zuvor bei der der Erfindung zugrundeliegenden Aufgabe geheissen hat, es solle die Funktionstüchtigkeit des eingangs beschriebenen
Schaltgerätes verbessert werden, dann ist dies in bezug auf die zuvor erläuterten Zweileitergeräte gemeint und hat dies zum Inhalt, den im labilen Schaltzustand "elektronischer Schalter gesperrt" über das in Rede
stehende Schaltgerät fließenden Strom gering zu halten.

Das erfindungsgemäße Schaltgerät, bei dem die zuvor dargelegte Aufgabe gelöst ist, weist als Zustandsindikator eine Licht emittierende Diode (LED)
auf und ist dadurch gekennzeichnet, daß der Zustandsindikator, also die
Licht emittierende Diode, während der Beeinflussungszustände IIa und IIb
Lichtimpulsfolgen unterschiedlicher Impulsfrequenz abgibt. Dieser Lehre
kommt auch losgelöst von der zuvor erläuterten Lehre erfinderische Bedeutung zu. Insbesondere ist diese Lehre auch auf das elektronische Schaltgerät, von dem die Erfindung ausgeht, anwendbar, wenn der mittlere Beeinflussungsbereich des Anwesenheitsindikators nicht in der zuvor erläuterten Weise unterteilt ist.

Während also bei dem elektronischen Schaltgerät, von dem die Erfindung
ausgeht, die Licht emittierende Diode im labilen Schaltzustand "elektronischer Schalter gesperrt" dauernd rot leuchtet, gibt bei dem erfindungsgemäßen elektronischen Schaltgerät die Licht emittierende Diode nur eine Lichtimpulsfolge ab. Folglich ist bei dem erfindungsgemäßen elektronischen Schaltgerät der im labilen Schaltzustand "elektronischer Schalter gesperrt" über das Schaltgerät notwendigerweise fließende Strom geringer als bei dem Schaltgerät, von dem die Erfindung ausgeht.

In bezug auf die zu realisierenden Impulsfrequenzen der beiden Lichtimpulsfolgen sind nur zwei Gesichtspunkte zu berücksichtigen. Einerseits müssen die Impulsfrequenzen so gewählt sein, daß die Lichtimpulsfolgen vom menschlichen Auge ohne weiteres wahrgenommen werden können. Andererseits müssen die beiden Impulsfrequenzen so weit auseinanderliegen, daß erkennbar ist, daß es sich um unterschiedliche Lichtimpulsfolgen handelt. Diesen Bedingungen ist bei einer bevorzugten Ausführungsform des erfindungsgemäßen elektronischen Schaltgerätes Rechnung getragen, die dadurch gekennzeichnet ist, daß der Zustandsindikator während des Beeinflussungszustandes IIa eine Lichtimpulsfolge mit einer Impulsfrequenz von ca. 2 Hz, während des Beeinflussungszustandes IIb eine Lichtimpulsfolge mit einer Impulsfrequenz von ca. 10 Hz abgibt.

Im folgenden wird die Erfindung anhand von zwei schematischen Skizzen erläutert; es zeigt

Fig. 1     das Blockschaltbild eines erfindungsgemäßen elektronischen Schaltgerätes und

Fig. 2     eine grafische Darstellung zur Erläuterung der Funktionsweise des erfindungsgemäßen Schaltgerätes.

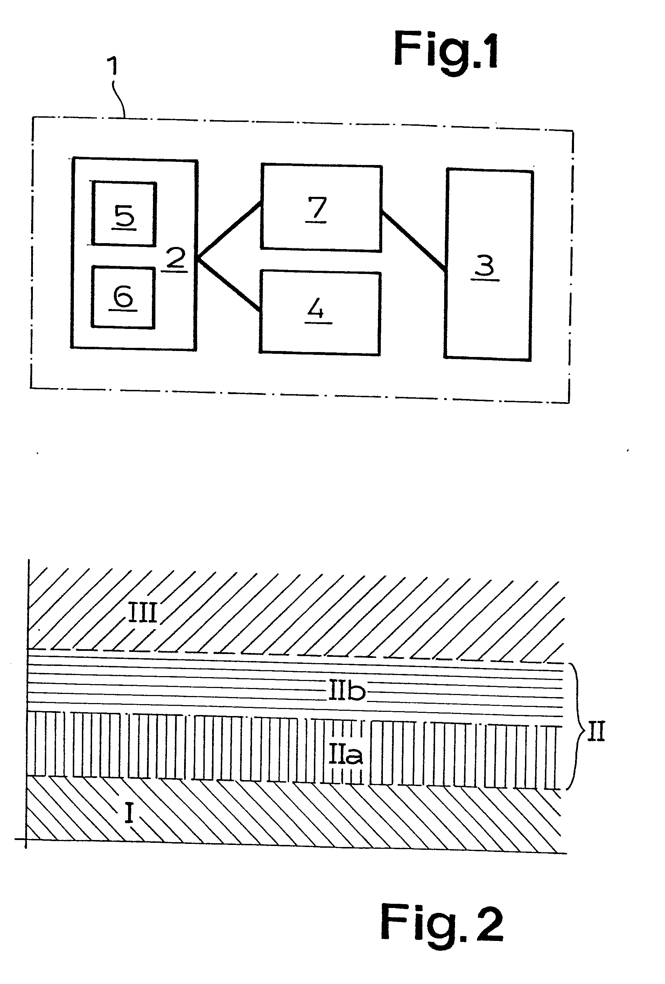

Das in Fig. 1 skizzierte elektronische Schaltgerät 1 arbeitet berührungslos und besteht in seinem wesentlichen Aufbau aus einem Anwesenheitsindikator 2, einem von dem Anwesenheitsindikator 2 steuerbaren elektronischen Schalter 3, z. B. einem Transistor, einem Thyristor oder einem Triac, und einem Zustandsindikator 4; das in Fig. 1 dargestellte elektronische Schaltgerät 1 ist ein optoelektronischer Annäherungsschalter, so daß zu dem Anwesenheitsindikator 2 ein Lichtsender 5 und ein Lichtempfänger 6 gehören.

Im dargestellten Ausführungsbeispiel ist zwischen dem Anwesenheitsindikator 2 und dem elektronischen Schalter 3 noch ein Schaltverstärker 7 vorgesehen.

Bei dem in Fig. 1 dargestellten elektronischen Schaltgerät 1 steuert der Anwesenheitsindikator 2 dann den elektronischen Schalter 3 um, wenn der Beeinflussungszustand des Anwesenheitsindikators 2 eine vorgegebene Ansprechschwelle überschreitet.

Durch den zu dem elektronischen Schaltgerät 1 nach Fig. 1 gehörenden Zustandsindikator 4 werden unterschiedliche Beeinflussungszustände des Anwesenheitsindikators 2 angezeigt, wie dies in Fig. 2 dargestellt ist. Zunächst gibt es den Beeinflussungszustand I, bei dem der Anwesenheitsindikator 2 des elektronischen Schaltgerätes 1 nicht (oder so gut wie nicht) beeinflußt ist, den Beeinflussungszustand II, bei dem der Anwesenheitsindikator 2 innerhalb eines mittleren Beeinflussungsbereiches beeinflußt ist, und den Beeinflussungszustand III, bei dem der Anwesenheitsindikator 2 oberhalb des mittleren Beeinflussungsbereiches beeinflußt ist.

Wie die Fig. 2 weiter zeigt, ist bei dem erfindungsgemäßen elektronischen Schaltgerät 1 der mittlere Beeinflussungsbereich des Abstandsindikators 2, Beeinflussungszustand II, in einen unterhalb der Ansprechschwelle liegenden Beeinflussungsbereich, Beeinflussungszustand IIa, und einen oberhalb der Ansprechschwelle liegenden Beeinflussungsbereich, Beeinflussungszustand IIb, unterteilt.

Im übrigen handelt es sich bei dem in Fig. 1 dargestellten elektronischen Schaltgerät 1 insoweit um eine besonders bevorzugte Ausführungsform, als der Zustandsindikator 4 als Licht emittierende Diode (LED) ausgeführt ist und während der Beeinflussungszustände IIa und IIb des Anwesenheitsindikators 2 Lichtimpulsfolgen unterschiedlicher Impulsfrequenz abgibt, nämlich während des Beeinflussungszustandes IIa eine Lichtimpulsfolge mit einer Impulsfrequenz von ca. 2 Hz und während des Beeinflussungszustandes IIb eine Lichtimpulsfolge mit einer Impulsfrequenz von ca. 10 Hz.

Patentansprüche:

1. Elektronisches, berührungslos arbeitendes Schaltgerät, mit einem von außen beeinflußbaren Anwesenheitsindikator, einem von dem Anwesenheitsindikator steuerbaren elektronischen Schalter, z. B. einem Transistor, einem Thyristor oder einem Triac, und einem Zustandsindikator, wobei der Anwesenheitsindikator dann den Schaltzustand des elektronischen Schalters umsteuert, wenn der Beeinflussungszustand des Anwesenheitsindikators eine vorgegebene Ansprechschwelle überschreitet, und wobei durch den Zustandsindikator unterschiedliche Beeinflussungszustände des Anwesenheitsindikators - Anwesenheitsindikator nicht beeinflußt (Beeinflussungszustand I), Anwesenheitsindikator innerhalb eines mittleren Beeinflussungsbereiches beeinflußt (Beeinflussungszustand II), Anwesenheitsindikator oberhalb des mittleren Beeinflussungsbereiches beeinflußt (Beeinflussungszustand III) - angezeigt werden, d a d u r c h  g e k e n n z e i c h n e t, daß der mittlere Beeinflussungsbereich des Anwesenheitsindikators (2) (Beeinflussungszustand II) in einen unterhalb der Ansprechschwelle liegenden Beeinflussungsbereich (Beeinflussungszustand IIa) und einen oberhalb der Ansprechschwelle liegenden Beeinflussungsbereich (Beeinflussungszustand IIb) unterteilt ist.

2. Elektronisches Schaltgerät nach Anspruch 1, wobei der Zustandsindikator als Licht emittierende Diode (LED) ausgeführt ist, dadurch gekennzeichnet, daß der Zustandsindikator (4) (die Licht emittierende Diode) während der Beeinflussungszustände IIa und IIb Lichtimpulsfolgen unterschiedlicher Impulsfrequenz abgibt.

3. Elektronisches Schaltgerät nach Anspruch 2, dadurch gekennzeichnet, daß der Zustandsindikator (4) während des Beeinflussungszustandes IIa eine Lichtimpulsfolge mit einer Impulsfrequenz von ca. 2 Hz abgibt.

4. Elektronisches Schaltgerät nach Anspruch 2 oder 3, dadurch gekennzeichnet, daß der Zustandsindikator (4) während des Beeinflussungszustandes IIb eine Lichtimpulsfolge mit einer Impulsfrequenz von ca. 10 Hz abgibt.

- 1 -

# Fig.1

1

# Fig.2